# EUROPÄISCHE PATENTSCHRIFT

(11) **EP 0 913 857 B1**
(45) Veröffentlichungstag und Bekanntmachung des Hinweises auf die Patenterteilung: **28.01.2004**
(21) Anmeldenummer: 97118882.6
(22) Anmeldetag: 30.10.1997
(51) Int. Cl.: H01L 21/00

(54) **Verfahren und Einrichtung für die Justierung des Bondkopfs einer Maschine für das Bonden von Halbleiterchips auf ein Trägermaterial**
Method and device for positioning the bonding head of a machine for the bonding of semiconductor chips as a carrier material
Méthode et dispositif pour le positionnement de la tête de jonction d'un appareil pour lier des plaquettes semi-conducteurs sur un substrat

(43) Veröffentlichungstag der Anmeldung: 06.05.1999
(73) Patentinhaber: ESEC Trading SA, 6330 Cham (CH)
(72) Erfinder: Mannhart, Eugen, Dr., 6330 Cham (CH); Ulrich, Alois, 6300 Zug (CH); Günther, Thomas, 8800 Thalwil (CH); Krieger, Matthias, Dr., 6312 Steinhausen (CH)
(74) Vertreter: Falk, Urs, Dr.

(56) Entgegenhaltungen:
- EP-A- 0 462 596
- US-A- 5 547 537
- PATENT ABSTRACTS OF JAPAN vol. 097, no. 007, 31.Juli 1997 -& JP 09 064094 A (TOSHIBA CORP), 7.März 1997,
- PATENT ABSTRACTS OF JAPAN vol. 018, no. 350 (E-1572), 30.Juni 1994 -& JP 06 089910 A (TOSHIBA CORP), 29.März 1994,

## Beschreibung

Die Erfindung betrifft ein Verfahren für die Justierung des Bondkopfs einer Maschine für das Bonden von Halbleiterchips auf ein Trägermaterial der im Oberbegriff des Anspruchs 1 genannten Art und dafür geeignete Einrichtungen.

Ein Die-Bonder ist eine Maschine, die einen Halbleiterchip auf ein Trägermaterial, insbesondere auf ein Leadframe, aufklebt (bondet). Eine solche Maschine wird z.B. in EP 0462596 beschrieben. Damit das nachfolgende Wire-Bonding problemlos erfolgen kann, muss die räumliche Lage des Bondkopfes des Die-Bonders derart eingestellt werden, dass der Halbleiterchip innerhalb festgelegter Toleranzen von etwa 10 µm planparallel auf dem Trägermaterial klebt.

Der Erfindung liegt die Aufgabe zugrunde, eine Einrichtung anzugeben, mit der der Bondkopf eines Bonders, insbesondere eines Die-Bonders auf einfache Weise justierbar ist.

Die Erfindung ist im Anspruch 1 gekennzeichnet. Vorteilhafte Einrichtungen zur Durchführung des erfindungsgemässen Verfahrens ergeben sich aus den abhängigen Ansprüchen.

Nachfolgend werden Ausführungsbeispiele der Erfindung anhand der Zeichnung näher erläutert.

Es zeigen:
- Fig. 1: einen Die-Bonder mit einer Einrichtung zur Justierung des Bondkopfes,
- Fig. 2a, b: die Einrichtung zur Justierung des Bondkopfes, bei der Spulen als Messmittel dienen,
- Fig. 3: eine Schaltung zum Betrieb der Spulen im Zeitmultiplex,
- Fig. 4: Spannungsdiagramme, und
- Fig. 5: die Einrichtung zur Justierung des Bondkopfes, bei der ein optisches Messmittel eingesetzt ist.

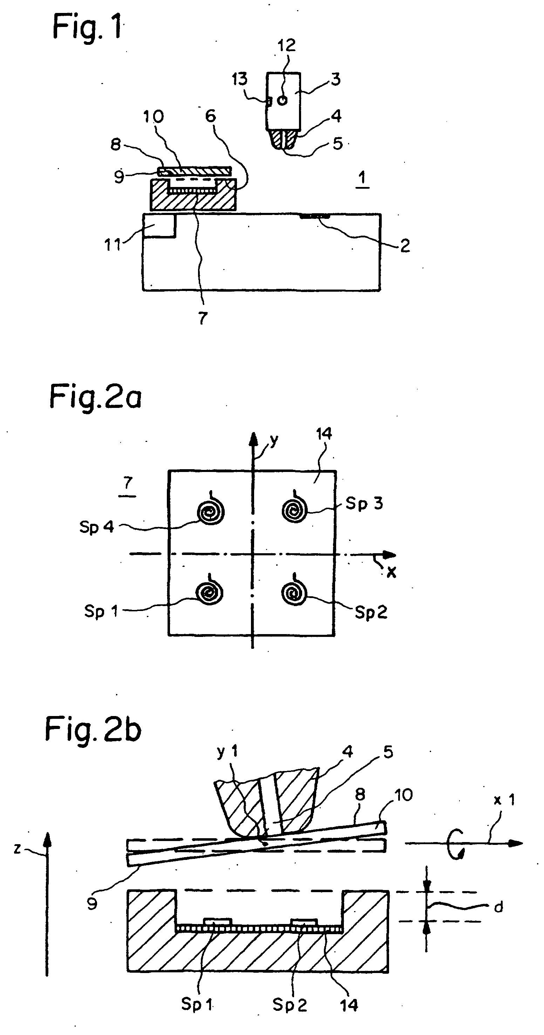

Die Erfindung wird nun anhand eines Die-Bonders 1 beschrieben. Die Fig. 1 zeigt schematisch den Die-Bonder 1 mit einer Bondfläche 2, auf der jeweils ein Halbleiterchip nach dem anderen auf ein Leadframe oder ein beliebiges anderes Trägermaterial gebondet wird. Der Halbleiterchip kann auch in sogenannter Flipchip Bauweise auf das Trägermaterial aufgebracht wird. Das Bonden eines Halbleiterchips erfolgt, indem der Bondkopf 3 des Die-Bonders 1 den Halbleiterchip an der dafür vorgesehenen Stelle durch Ansaugen mit Vakuum erfasst und auf dem Leadframe plaziert. Der Bondkopf 3 weist ein Gummiteil 4 mit einer Ansaugöffnung 5 auf, damit der Halbleiterchip die Ansaugöffnung 5 dicht abschliessen kann.

Für Halbleiterchips unterschiedlicher Grösse wird der Bondkopf 3 mit Gummiteilen 4 unterschiedlicher Grösse ausgerüstet. Nach jedem Auswechseln des Gummiteils 4 muss der Bondkopf 3 neu justiert werden. Nach der Justierung muss der Bondkopf 3 den Halbleiterchip derart auf das Trägermaterial bonden, dass keine Stelle des Randes der Oberfläche des Halbleiterchips eine andere Stelle seiner Oberfläche um mehr als etwa 10 µm überragt. Der Die-Bonder 1 weist nun für die Justierung eine Auflagefläche 6 auf, die planparallel zur Bondfläche 2 ausgerichtet ist. Unmittelbar unterhalb der Auflagefläche 6 ist ein mit der Auflagefläche 6 fest verbundenes Messmittel 7 angeordnet, das von der aktuellen Lage eines mit zwei planparallelen Flächen 8 und 9 versehenen Justierplättchens 10 abhängige Signale liefert. Die Signale werden von einem Anzeigemittel 11 visuell angezeigt. Der Bondkopf 3 ist manuell mittels zweier Schrauben 12 und 13 oder mittels elektrischer Antriebe um zwei Achsen drehbar, damit ein von ihm zu plazierender Halbleiterchip innerhalb vorgegebener Toleranzen planparallel zur Bondfläche 2 geklebt werden kann.

Die Justierung des Bondkopfes 3 erfolgt gemäss den folgenden Schritten:
a) Plazieren des Justierplättchens 10 auf der Auflagefläche 6.
b) Kalibrieren des Messmittels 7.
c) Erfassen des Justierplättchens 10 mit dem Gummiteil 4 des Bondkopfes 3 und Halten des Justierplättchens 10 in geringem Abstand über dem Messmittel 7.
d) Verstellen des Bondkopfes 3, manuell oder automatisch, bis das Signal des Messmittels 7 gleich dem Signal nach dem Schritt b ist.

Nach dem Schritt a befindet sich das Justierplättchen 10 in einer vorbestimmten, zur Bondfläche 2 planparallelen Referenzlage. Die in dieser Lage des Justierplättchens 10 vom Messmittel 7 gelieferten Signale werden beim Schritt b erfasst. Nach dem Schritt c befindet sich das Justierplättchen 10 in einer durch die aktuelle Einstellung des Bondkopfes 3 und das Gummiteil 4 bestimmten Schräglage. Beim Schritt d wird nun die Schräglage des Justierplättchens 10 der Referenzlage angeglichen, bis die Signale anzeigen, dass das Justierplättchen 10 vom Bondkopf 3 so gehalten ist, dass es planparallel zur Bondfläche 2 ist.

Unter Kalibrieren des Messmittels 7 ist zu verstehen, dass das oder die vom Messmittel 7 in der Referenzlage des Justierplättchens 10 gelieferten Signale gemessen und gespeichert werden oder dass das Messmittel 7 in der Referenzlage des Justierplättchens 10 derart eingestellt wird, dass sein Signal einen vorbestimmten Wert anzeigt, beispielsweise den Wert "0". Der Verfahrensschritt b wird nachfolgend an Beispielen näher erläutert.

Als Material für das Justierplättchen 10 eignet sich z.B. Polycarbonat, wobei wenigstens die Fläche 9, vorzugsweise jedoch beide Flächen 8 und 9 metallisiert sind. Das Gewicht des Justierplättchens 10 liegt mit wenigen Gramm dann innerhalb des Bereiches, den auch Halbleiterchips unterschiedlicher Grösse abdecken.

Herkömmlichen Verfahren zur Justierung des Bondkopfes 3 haftet der Nachteil an, dass das Gummiteil 4 nicht einbezogen ist. Das Gummiteil 4 ist jedoch selbst eine Quelle für ungewollte Schräglage (Tilt), da die Ansaugöffnung 5 eines solches Teils nicht mit der erforderlichen Genauigkeit herstell- und am Bondkopf 3 montierbar ist. Der Vorteil des erfindungsgemässen Verfahrens besteht darin, dass auch der durch das unverzichtbare Gummiteil 4 des Bondkopfes 3 selbst bewirkte Tilt der Halbleiterchips eliminiert wird.

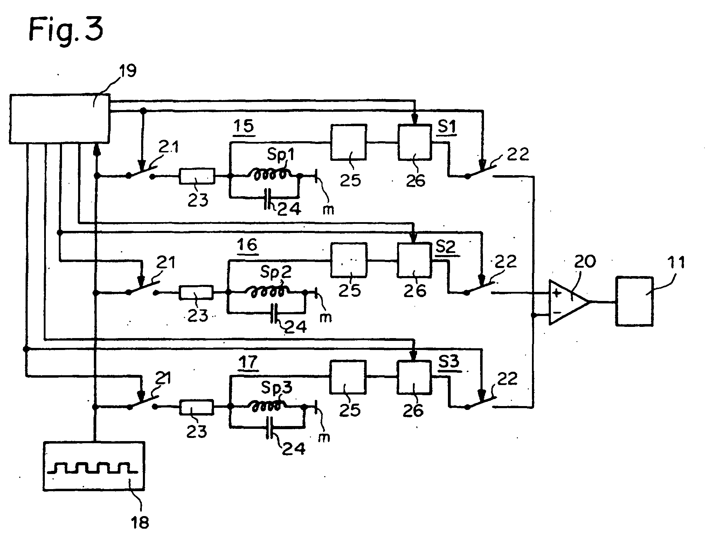

Als vorteilhaftes Messprinzip eignet sich die bewährte induktive Abstandsmessung, bei der der ohmsche Widerstand und/oder die Induktivität einer mit einem Wechselstrom erregten Spule ändert, wenn ein metallischer oder ferromagnetischer Gegenstand in ihrem magnetischen Nahfeld bewegt wird. Die Fig. 2a und b zeigen in der Draufsicht bzw. in der Seitenansicht ein bevorzugtes Ausführungsbeispiel, bei dem als Messmittel 7 eine mit wenigstens drei Spulen Sp1, Sp2 und Sp3, vorzugsweise jedoch mit vier Spulen Sp1, Sp2, Sp3 und Sp4 versehene Leiterplatte 14 dient. Die Spulen Sp1, Sp2, Sp3 und Sp4 sind in den vier Quadranten eines kartesischen xy-Koordinatensystems symmetrisch bezüglich des Ursprungs angeordnet. Die Leiterplatte 14 ist etwa im Abstand d von einem Millimeter planparallel zur Auflagefläche 6 angeordnet. Die Spulen Sp1, Sp2, Sp3 und Sp4 sind aus Leiterbahnen gebildete Flachspulen. Die den Spulen Sp1, Sp2, Sp3 und Sp4 zugewandte Fläche 9 des Justierplättchens 10 weist eine metallisierte oder eine ferromagnetische Oberfläche auf. Jede der Spulen Sp1, Sp2, Sp3 und Sp4 liefert dann ein Signal S1, S2, S3 bzw. S4, das vom Abstand z der entsprechenden Spule Sp1, Sp2, Sp3 bzw. Sp4 zum Justierplättchen 10 abhängt. Unter dem Signal S1, S2, S3 bzw. S4 der entsprechenden Spule Sp1, Sp2, Sp3 bzw. Sp4 ist bereits das elektronisch aufbereitete Signal zu verstehen (siehe Fig. 3). Bei einer Drehung des Justierplättchens 10 im Uhrzeigersinn um die fiktive Achse y1 infolge einer Verstellung des Bondkopfes 3 verkleinern sich die Signale S2 und S3 der Spulen Sp2 bzw. Sp3, während sich die Signale S 1 und S4 der Spulen Sp1 bzw. Sp4 vergrössern. Somit verkleinern sich auch die beiden Differenzsignale S2-S1 und S3-S4. Bei einer Drehung des Justierplättchens 10 im Uhrieigersinn um die fiktive Achse x1 infolge einer anderen Verstellung des Bondkopfes 3 verkleinern sich die Signale S 1 und S2, während sich die Signale S3 und S4 vergrössern. In diesem Fall verkleinern sich die beiden Differenzsignale S2-S3 und S1-S4. Wenn die Leiterplatte 14 vollständig plan ist und alle Spulen die gleiche Kennlinie S(z) aufweisen, dann verschwinden die beiden Differenzsignale D1=S2-S1 und D2=S2-S3 genau dann, wenn das Justierplättchen 10 vom Bondkopf 3 in einer zur Leiterplatte 14 planparallelen Lage gehalten wird.

Da nun die Leiterplatte 14 infolge unvermeidlicher Fertigungstoleranzen nicht notwendigerweise innerhalb der geforderten Genauigkeit planparallel zur Auflagefläche 6 bzw. zur Bondfläche 2 (Fig. 1) ausgerichtet ist, und da die Spulen Sp1, Sp2, Sp3 und Sp4 in der Regel unterschiedliche Kennlinien S1(z), S2(z), S3(z) bzw. S4(z) aufweisen, ist wenigstens einmal ein Kalibriervorgang durchzuführen. Bei diesem Kalibriervorgang wird das Justierplättchen 10 auf der Auflagefläche 6 plaziert und dann werden entweder i) die Differenzsignale D1ₖₐₗ=S2ₖₐₗ-S1ₖₐₗ und D2ₖₐₗ=S2ₖₐₗ-S3ₖₐₗ gespeichert oder es werden ii) die Signale S1ₖₐₗ und S3ₖₐₗ abgeglichen, bis sie den Wert S2ₖₐₗ aufweisen, d.h. bis die Differenzsignale D1 und D2 verschwinden, d.h. D1 = 0 und D2 = 0 ist.

Im Fall i) erfolgt anschliessend die Justierung des Bondkopfes 3 gemäss dem Schritt d, indem der das Justierplättchen 10 frei haltende Bondkopf 3 verstellt wird, bis die Differenzsignale D1 und D2 die Werte D1=D1ₖₐₗ bzw. D2=D2ₖₐₗ aufweisen. Im Fall ii) erfolgt die Justierung des Bondkopfes 3, indem der Bondkopf 3 verstellt wird, bis die Differenzsignale D1 und D2 verschwinden. Dabei wird beispielsweise die Schaltung zuerst so betrieben, dass abwechslungsweise die Spulen Sp1 und Sp2 mit dem Oszillatorsignal beaufschlagt und das Differenzsignal D1=S2-S1 zur Anzeige gebracht werden, so dass das Differenzsignal D1 durch Verstellen des Bondkopfes 3 mittels der Schraube 12 zum Verschwinden gebracht werden kann. Anschliessend werden abwechslungsweise die Spulen Sp3 und Sp2 beaufschlagt und das Differenzsignal D2=S2-S3 zur Anzeige gebracht, so dass das Differenzsignal D2 durch Verstellen des Bondkopfes 3 mittels der Schraube 13 zum Verschwinden gebracht werden kann.

Es hängt von der Stabilität des Messmittels 7 bezüglich äusserer Einflüsse wie Temperatur, Feuchtigkeit, etc. ab, ob der Kalibriervorgang bei jeder Justierung des Bondkopfes 3 oder nur gelegentlich durchgeführt werden muss.

Für die Justierung genügen an sich die drei Spulen Sp1, Sp2 und Sp3. Aus Gründen der Redundanz kann es jedoch nützlich sein, auch die vierte Spule Sp4 miteinzubeziehen. Da sich die nahe nebeneinander angeordneten Spulen Sp1, Sp2 und Sp3 gegenseitig beeinflussen können, wird eine Betriebsart bevorzugt, bei der immer nur eine der Spulen Sp1, Sp2 bzw. Sp3 ein nennenswertes Magnetfeld erzeugt.

Die Fig. 3 zeigt eine Schaltung zum Betrieb der Spulen Sp1, Sp2 und Sp3 im Zeitmultiplex. Die Spulen Sp1, Sp2 und Sp3 sind in parallelen Pfaden 15 - 17 angeordnet. Die Schaltung weist einen Oszillator 18, eine Steuereinrichtung 19 und einen Differenzbildner 20 auf, dessen Ausgang auf das Anzeigemittel 11 geführt ist. Jeder Pfad 15 - 17 weist eingangsseitig und ausgangsseitig einen von der Steuereinrichtung 19 betätigbaren Schalter 21 bzw. 22 auf. Der Schalter 21 ist mit dem Oszillator 18 verbunden. Der Ausgang jeden Pfades 15 - 17 ist auf den Differenzbildner 20 geführt. Dem Schalter 21 nachgeschaltet ist ein Widerstand 23 und ein Kondensator 24, wobei der Kondensator 24 parallel zur entsprechenden Spule Sp1, Sp2 bzw. Sp3 liegt. Jeweils ein Anschluss der Spule und des Kondensators 24 liegen an Masse m, während der mit dem Widerstand 23 verbundene Anschluss zu einem Detektor 25 und einem nachfolgenden Sample&Hold Baustein 26 geführt ist. Der Ausgang des Sample&Hold Bausteins 26 bildet den Ausgang des Pfades. Der Sample&Hold Baustein 26 wird jeweils von der Steuereinrichtung 19 aktiviert zum Erfassen und Speichern eines neuen Wertes. Als Detektor 25 kann z.B. ein Peak-, Amplituden- oder ein Synchrondetektor eingesetzt werden. Der Differenzbildner 20 ist z.B. ein als Differenzverstärker geschalteter Operationsverstärker, dessen invertierendem Eingang entweder das Signal S 1 oder das Signal S3 und dessen nicht invertierendem Eingang das Signal S2 zugeführt wird, so dass auf dem nachgeschalteten Anzeigemittel 11 das Differenzsignal D1=S2-S1 bzw. das Differenzsignal D2=S2-S3 zur Anzeige gebracht ist.

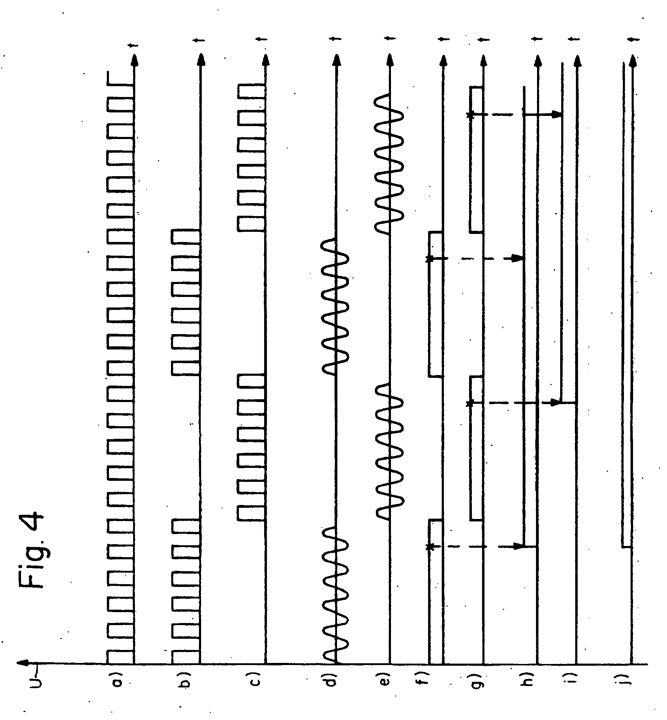

Die Schalter 21 und 22 werden von der Steuereinrichtung 19 zyklisch ein- und ausgeschaltet, so dass immer nur einer der Pfade 15 - 17 in Betrieb ist. Die Fig. 4 zeigt nun für den Fall, dass der Bondkopf 3 mittels des Differenzsignales D1=S2-S1 justiert werden soll, den Verlauf folgender Spannungen U in Funktion der Zeit t:
a) Spannung am Ausgang des Oszillators 18,
b) Spannung nach dem Schalter 21 des Pfades 15 mit der Spule Sp1,
c) Spannung nach dem Schalter 21 des Pfades 16 mit der Spule Sp2,
d) Spannung am Eingang des Detektors 25 des Pfades 15,
e) Spannung am Eingang des Detektors 25 des Pfades 16,
f) Spannung am Ausgang des Detektors 25 des Pfades 15,
g) Spannung am Ausgang des Detektors 25 des Pfades 16,
h) Spannung am Ausgang des Sample&Hold Bausteins 26 des Pfades 15,
i) Spannung am Ausgang des Sample&Hold Bausteins 26 des Pfades 16, und
j) Spannung am Ausgang des Differenzbildners 20.

Eingetragen sind auch die Zeitpunkte, an denen die Steuereinrichtung 19 den Sample&Hold Baustein 26 anweist, einen neuen Messwert zu erfassen. Die Frequenz, mit der der Oszillator 18 die Flachspulen Sp1 - Sp3 beaufschlagt, liegt zwischen etwa 1 und 10 Mhz, bevorzugt beträgt sie 4 Mhz. Die Kapazität der Kondensatoren 24 ist so anzupassen, dass die Resonanzfrequenz des durch den Kondensator 24 und die entsprechende Spule Sp1, Sp2 oder Sp3 gebildeten Schwingkreises etwa der Oszillatorfrequenz entspricht. Bevorzugt ist die Oszillatorfrequenz so gewählt, dass sie in der Mitte der aufsteigenden. Flanke des Resonanzpeaks liegt, wo die Ableitung des Signals der Spule Sp1, Sp2 bzw. Sp3 nach der Oszillatorfrequenz gross ist. Das vom Oszillator 18 erzeugte Signal ist mit Vorteil rechteckförmig. Anstelle des Oszillators 18 könnte somit auch ein Mikroprozessor mit einem entsprechenden Ausgang verwendet werden. Die Steuereinrichtung 19 leitet aus der vom Oszillator 18 erzeugten Frequenz durch Herunterteilen die Frequenz ab, mit der die Schalter 21 und 22 der drei Pfade 15 - 17 zu öffnen und zu schliessen sind und mit der die Sample&Hold Bausteine 26 anzusteuern sind.

Die Bauelemente der Schaltung sind mit Vorteil direkt auf die Unterseite der Leiterplatte 14 montiert, was die Robustheit gegen Störungen infolge äusserer Einflüsse stark vergrössert.

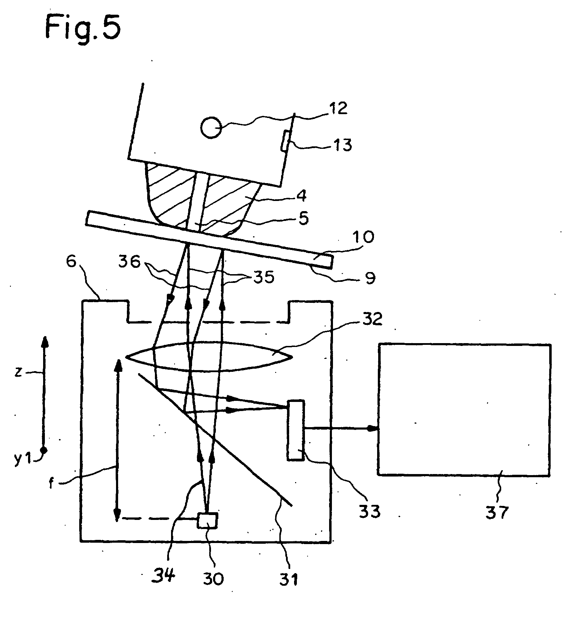

Die Fig. 5 zeigt ein Ausführungsbeispiel, bei dem als Messmittel 7 ein optisches System dient. Die Fläche 9 des Justierplättchens 10 ist in diesem Fall eine optisch gut reflektierende Fläche, z.B. eine spiegelnde Fläche. Das optische System weist eine Lichtquelle 30, einen teildurchlässigen Spiegel 31, eine Linse 32 und einen Photodetektor 33 auf. Die Lichtquelle 30 und der Photodetektor 33 befinden sich im Brennpunkt f bzw. in der Brennebene der Linse 32. Das von der punktförmigen Lichtquelle 30 ausgehende Licht 34 trifft wegen der Linse 32 als ebene Welle 35 auf die Fläche 9 des Justierplättchens 10, wird dort reflektiert und vom teildurchlässigen Spiegel 31 wenigstens teilweise zum Photodetektor 33 reflektiert, wobei die Linse 32 das reflektierte parallele Licht 36 wiederum auf den Photodetektor 33 fokussiert. Als Photodetektor 33 ist mit Vorteil ein zweidimensionaler Array von Photosensoren eingesetzt, der z.B. als CCD (charge coupled device) oder PSD (photosensitive device) erhältlich ist. Als Anzeigemittel 11 für die von den Photosensoren gelieferten Bildsignale kann ein normaler Bildschirm 37 verwendet werden. Bei der Kalibrierung des optischen Systems gemäss dem Punkt b des Verfahrens wird die Lage des Photodetektors in y1- und in z-Richtung verändert, bis der dem reflektierten wird die Lage des Photodetektors in y1- und in z-Richtung verändert, bis der dem reflektierten Lichtstrahl 36 entsprechende Lichtpunkt im Zentrum des Bildschirms 37 erscheint. Die Richtung y1 ist in der Zeichnung senkrecht zur Zeichnungsfläche. Beim Justieren gemäss dem Punkt d des Verfahrens wird der Bondkopf 3 verstellt, bis der dem reflektierten Lichtstrahl 36 entsprechende Lichtpunkt wiederum im Zentrum des Bildschirms 37 erscheint.

Die beschriebenen Einrichtungen zur Justierung des Bondkopfes 3 des Die-Bonders 1 können im Die-Bonder 1 integriert oder als Zubehör lieferbar sein, damit bestehende Die-Bonder 1 nachgerüstet werden können. Im letzteren Fall muss die Auflagefläche 6 planparallel zur Bondfläche 2 ausgerichtet werden, bevor die Justierung des Bondkopfes 3 durchgeführt werden kann.

## Patentansprüche

1. Verfahren für die Justierung des Bondkopfs einer Maschine für das Bonden von Halbleiterchips auf ein Trägermaterial, **gekennzeichnet durch folgende Schritte**:
a) Plazieren eines mit zwei planparallelen Flächen (8, 9) versehenen Justierplättchens (10) auf einer Auflagefläche (6), die planparallel zu der Bondfläche (2) ausgerichtet ist, auf der die Halbleiterchips auf das Trägermaterial gebondet werden;
b) Kalibrieren eines Messmittels (7), dessen Signal von der Lage des Justierplättchens (10) abhängt;
c) Erfassen des Justierplättchens (10) mit dem Bondkopf (3) der Maschine und Halten des Justierplättchens (10) in geringem Abstand über dem Messmittel (7);
d) Justieren des Bondkopfes (3), bis das Signal des Messmittels (7) gleich dem Signal nach dem Schritt b ist.

2. Verfahren nach Anspruch 1**, dadurch gekennzeichnet, dass** bei wiederholter Justierung die Schritte a und b weggelassen sind.

3. Einrichtung zur Durchführung des Verfahrens nach Anspruch 1 oder 2, **dadurch gekennzeichnet, dass** das Justierplättchen (10) eine metallisierte oder ferromagnetische Fläche (9) aufweist, dass das Messmittel (7) wenigstens drei Spulen (Sp1, Sp2, Sp3) aufweist, die in einer zur Auflagefläche (6) annähernd parallelen Ebene angeordnet sind, und dass ein Anzeigemittel (11) vorhanden ist, mit dem wenigstens die Differenz der von zwei der drei Spulen (Sp1, Sp2, Sp3) gelieferten Signale (S1, S2, S3) darstellbar ist.

4. Einrichtung zur Durchführung des Verfahrens nach Anspruch 3, **dadurch gekennzeichnet, dass** zu jedem Zeitpunkt immer nur eine der Spulen (Sp1, Sp2, Sp3) ein nennenswertes Signal (S1, S2, S3) erzeugt.

5. Einrichtung zur Durchführung des Verfahrens nach Anspruch 3 oder 4, **dadurch gekennzeichnet, dass** die Spulen (Sp1, Sp2, Sp3) im Zeitmultiplex betrieben werden.

6. Einrichtung zur Durchführung des Verfahrens nach Anspruch 1, **dadurch gekennzeichnet, dass** das Justierplättchen (10) eine optisch gut reflektierende Fläche (9) aufweist und dass das Messmittel (7) ein optisches System (30, 31, 32, 33) ist, welches das Justierplättchen (10) mit einem Strahl parallelen Lichts (35) beleuchtet.

## Claims

1. A method of aligning the bonding head of an apparatus for bonding semiconductor chips to a carrier material (1), **characterised by** the following steps:
a) placing an alignment plate (10) provided with two plane parallel surfaces (8, 9) on a supporting surface (6) which extends plane parallel to the bonding surface (2), upon which the semiconductor chip is to be bonded to the carrier material;
b) calibrating a measuring means (7) the signal of which is dependent upon the position of the alignment plate (10);
c) grasping the alignment plate (10) with the bonding head (3) of the apparatus and holding the alignment plate (10) a small distance above the measuring means (7);
d) aligning the bonding head (3) until the signal of the measuring means (7) is equal to the signal following step b).

2. A method according to claim 1, **characterised in that** by repeated alignment steps a) and b) are omitted.

3. An apparatus for implementing the method according to claim 1 or 2, **characterised in that** the alignment plate (10) has a metallised or ferromagnetic surface (9), that the measuring means (7) has at least three coils (Sp1, Sp2, Sp3) which are arranged in a plane approximately parallel to the supporting surface (6), and **in that** a display means (11) is provided with which at least the difference between two of the signals (S1, S2, S3) supplied by the three coils (Sp1, Sp2, Sp3) can be represented.

4. An apparatus for implementing the method according to claim 3, **characterised in that**, at any one time, only one of the coils (Sp1, Sp2, Sp3) produces a significant signal (S1, S2, S3).

5. An apparatus for implementing the method according to claim 3 or 4, **characterised in that** the coils (Sp1, Sp2, Sp3) are operated in time division multiplex.

6. An apparatus for implementing the method according to claim 1, **characterised in that** the alignment plate (10) has an optically good reflecting surface (9) and that the measuring means (7) is an optical system (30, 31, 32, 33) which illuminates the alignment plate with a beam of parallel light (35).

## Revendications

1. Procédé pour l'ajustement de la tête de montage d'une machine destinée à monter des puces de semi-conducteurs sur un matériau de support, **caractérisé en ce qu'il comprend les étapes suivantes** :
a) positionnement d'une plaquette d'ajustement (10) pourvue de deux surfaces parallèles (8, 9) sur une surface d'appui (6) orientée parallèlement à la surface de montage (2) sur laquelle les puces de semi-conducteurs sont montées sur le matériau de support ;
b) étalonnage d'un moyen de mesure (7) dont le signal dépend de la position de la plaquette d'ajustement (10) ;
c) prendre la plaquette d'ajustement (10) avec la tête de montage (3) de la machine et maintenir la plaquette d'ajustement (10) à faible distance au-dessus du moyen de mesure (7) ;
d) ajustement de la tête de montage (3) jusqu'à ce que le signal du moyen de mesure (7) soit égal au signal selon l'étape b.

2. Procédé selon la revendication 1, **caractérisé en ce que** les étapes a et b sont omises en cas d'ajustement répété.

3. Dispositif pour la mise en oeuvre du procédé selon la revendication 1 ou 2, **caractérisé en ce que** la plaquette d'ajustement (10) présente une surface métallisée ou ferromagnétique (9), **en ce que** le moyen de mesure (7) présente au moins trois bobines (Sp1, Sp2, Sp3) qui sont disposées dans un plan approximativement parallèle à la surface de pose (6), et **en ce qu'**il est prévu un moyen d'affichage (11) avec lequel la différence des signaux (S1, S2, S3) de deux des trois bobines (Sp1, Sp2, Sp3) au moins peut être affichée.

4. Dispositif pour la mise en oeuvre du procédé selon la revendication 3, **caractérisé en ce qu'**une seule des bobines (Sp1, Sp2, Sp3) produit à tout moment donné un signal (S1, S2, S3) notable.

5. Dispositif pour la mise en oeuvre du procédé selon la revendication 3 ou 4, **caractérisé en ce que** les bobines (Sp1, Sp2, Sp3) fonctionnent en multiplexage temporel.

6. Dispositif pour la mise en oeuvre du procédé selon la revendication 1, **caractérisé en ce que** la plaquette d'ajustement (10) présente une surface bien réfléchissante du point de vue optique (9) et **en ce que** le moyen de mesure (7) est un système optique (30, 31, 32, 33) qui éclaire la plaquette d'ajustement (10) avec un faisceau de lumière parallèle (35).
